# EUROPEAN PATENT APPLICATION

(11) **EP 1 753 028 A2**
(43) Date of publication of application: **14.02.2007**
(21) Application number: 06014638.8
(22) Date of filing: 14.07.2006
(51) Int. Cl.: H01L 25/065, H01L 25/18

(54) **Receiver chips receiving different types of digital signals bonded on a monolithic integrated circuit semiconductor substrate**

(30) Priority: 26.07.2005 KR 20050067808
(71) Applicant: Integrant Technologies Inc., Seongnam-si, Gyoenggi-do 463-810 (KR)
(72) Inventor: Jeong, Minsu, Dongan-go Anyang-si Gyeonggi-do (KR); Kim, Bo-Eun, Giheung-eup Yongin-si Gyeonggi-do (KR); Kim, Bonkee, Bundang-gu Seongnam-si Gyeonggi-do (KR)
(74) Representative: Jakelski, Joachim

(57) **Abstract**

The present invention relates to a receiver chip formed on a monolithic semiconductor integrated circuit substrate. The receiver chip comprises a first receiver chip for receiving terrestrial digital multimedia broadcasting signals, a second receiver chip for receiving satellite digital multimedia broadcasting signals, and the monolithic semiconductor integrated circuit substrate. The first and second receiver chips are stacked and bonded on the monolithic semiconductor integrated circuit substrate.

## Description

This Nonprovisional application claims priority under 35 U.S.C. § 119(a) on Patent Application No. 10-2005-0067808 filed in Korea on July 26, 2005, the entire contents of which are hereby incorporated by reference.

### BACKGROUND OF THE INVENTION

### Field of the Invention

The present invention relates to a semiconductor chip, more particularly, to a receiver chip which embodies receiver chips for terrestrial digital multimedia broadcasting (T-DMB), satellite digital multimedia broadcasting (S-DMB), or wireless broadband internet (WiBro) communications on one chip.

### Description of the Background Art

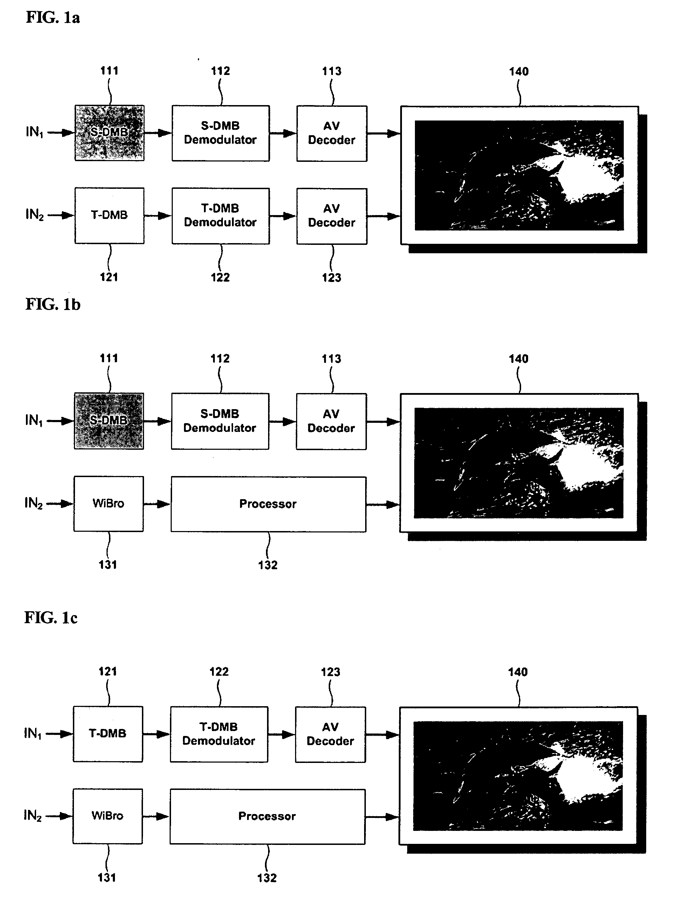

FIG. 1A is a block diagram illustrating a conventional receiver configured with a receiver chip for receiving S-DMB signals and a receiver chip for receiving T-DMB signals .

As shown in FIG. 1A, a display device 140 displays images received through a S-DMB receiver chip 111 for receiving S-DMB signals and a T-DMB receiver chip 121 for receiving T-DMB signals.

The signals outputted from the S-DMB receiver chip 111 are demodulated by a S-DMB demodulator 112, and the demodulated signals are converted to image signals by an AV decoder 113 to be displayed on the display device 140.

In the same way, the signals outputted from the T-DMB receiver chip 121 are demodulated by a T-DMB demodulator 122, and the demodulated signals are converted to image signals by an AV decoder 123 to be displayed on the display device 140.

Therefore, all of the S-DMB, T-DMB receiver chip 111 and 121, the demodulators 112 and 122, and the AV decoders 113 and 123 are required to configure the receiver in order to receive S-DMB signal and T-DMB signal, each having different receiving bandwidth, respectively.

As a result, this configuration has shortcomings to increase its volume and power consumption and complicate the manufacturing process then to deteriorate the productivity.

FIG. 1B and FIG. 1C are block diagrams illustrating conventional receivers configured with receiver chips each having different receiving bandwidth, respectively.

As shown in FIG. 1B, a display device 140 displays images received 140 through a S-DMB receiver chip 111 for receiving S-DMB signals and a WiBro receiver chip 131 for receiving WiBro signals.

The signals outputted from the S-DMB receiver chip 111 are demodulated by a S-DMB demodulator 112, and the demodulated signals are converted to image signals by an AV decoder 113 to be displayed on the display device 140.

Likewise, the signals outputted from the WiBro receiver chip 131 are processed by a WiBro processor 132 to be displayed on the display device 140.

Herein, the term of WiBro is an abbreviated word of the wireless broadband internet and designates a wireless mobile internet service to display images on a display device via the wireless internet.

As shown in FIG. 1C, a display device 140 displays images received through a T-DMB receiver chip 121 for receiving T-DMB signals and a WiBro receiver chip 131 for receiving WiBro signals.

The receiver with the T-DMB receiver chip 121 and the WiBro receiver chip 131 can be understood by the explanation of FIG. 1B.

These receivers illustrated FIG. 1B and FIG. 1C also have shortcomings to increase their volume and power consumption and complicate the manufacturing process then to deteriorate the productivity.

### SUMMARY OF THE INVENTION

Accordingly, an aspect of the present invention is to solve at least the problems and disadvantages of the background art. The present invention has been made in an effort to reduce the power consumption of the receiver formed on a monolithic semiconductor integrated circuit substrate. Also, the present invention has been made in an effort to minimize the receiver.

In accordance with an aspect of the present invention, a receiver chip formed on a monolithic semiconductor integrated circuit substrate comprises a first receiver chip for receiving terrestrial digital multimedia broadcasting signals, a second receiver chip for receiving satellite digital multimedia broadcasting signals, and the monolithic semiconductor integrated circuit substrate. The first receiver chip comprises a first bonding portion comprising a plurality of pads, the second receiver chip comprises a second bonding portion comprising a plurality of pads, and the monolithic semiconductor integrated circuit substrate comprises a third bonding portion comprising a plurality of pads. The first and second receiver chips are stacked and bonded on the monolithic semiconductor integrated circuit substrate, and the pads of the first or second bonding portion are wire-bonded to the pads of the third bonding portion.

Herein, common pads capable of being used commonly in the first and second bonding portions may be wire-bonded to each other.

In accordance with another aspect of the present invention, a receiver chip formed on a monolithic semiconductor integrated circuit substrate comprises a first receiver chip for receiving terrestrial digital multimedia broadcasting signals, a second receiver chip for receiving satellite digital multimedia broadcasting signals, and the monolithic semiconductor integrated circuit substrate. The first receiver chip comprises a first bonding portion comprising a plurality of pads, the second receiver chip comprises a second bonding portion comprising a plurality of pads, and the monolithic semiconductor integrated circuit substrate comprises a third bonding portion comprising a plurality of pads. The first and second receiver chips are bonded adjacently to each other on the monolithic semiconductor integrated circuit substrate, and the pads of the first or second bonding portion are wire-bonded to the pads of the third bonding portion.

Herein, common pads capable of being used commonly in the first and second bonding portions may be wire-bonded to each other.

In accordance with another aspect of the present invention, a receiver chip formed on a monolithic semiconductor integrated circuit substrate comprises a first receiving block for receiving terrestrial digital multimedia broadcasting signals, a second receiving block for receiving satellite digital multimedia broadcasting signals, and a common block used commonly by the first and second receiving blocks. The first receiving block, the second receiving block, and the common block are isolated one another and formed on one chip to be bonded on the monolithic semiconductor integrated circuit substrate.

Herein, the common block may comprise one or more of a phase locked loop, a local oscillator, or a phase local oscillator.

In accordance with another aspect of the present invention, a receiver chip formed on a monolithic semiconductor integrated circuit substrate comprises a first receiver chip for receiving digital multimedia broadcasting signals, a second receiver chip for communicating in a wireless broadband internet (WiBro) scheme, and the monolithic semiconductor integrated circuit substrate. The first receiver chip comprises a first bonding portion comprising a plurality of pads, the second receiver chip comprises a second bonding portion comprising a plurality of pads, and the monolithic semiconductor integrated circuit substrate comprises a third bonding portion comprising a plurality of pads. The first and second receiver chips are stacked and bonded on the monolithic semiconductor integrated circuit substrate, and the pads of the first or second bonding portion are wire-bonded to the pads of the third bonding portion.

Herein, the first receiver chip may be one of a satellite digital multimedia broadcasting receiver chip or a terrestrial digital multimedia broadcasting receiver chip.

Herein, common pads capable of being used commonly in the first and second bonding portions may be wire-bonded to each other.

In accordance with another aspect of the present invention, a receiver chip formed on a monolithic semiconductor integrated circuit substrate comprises a first receiving block for receiving digital multimedia broadcasting signals, a second receiving block for communicating in a WiBro scheme, and a common block used commonly by the first and second receiving blocks. The first receiving block, the second receiving block, and the common block are isolated from one another and formed on the monolithic semiconductor integrated circuit substrate.

Herein, the common block may comprise one or more of a phase locked loop, a local oscillator, or a phase local oscillator.

Herein, the first receiving block may be one of a satellite digital multimedia broadcasting receiving chip or a terrestrial digital multimedia broadcasting receiving chip.

The other details of the embodiments are comprised in the following description of the preferred embodiments and the accompanying drawings.

The above and other advantages, features, and the accomplishing method thereof will become better understood with reference to the preferred embodiments described later in detail in conjunction with the accompanying drawings. The invention may, however, be embodied in many different forms and should not be construed as being limited to the embodiments set forth herein; rather, these embodiments are provided so that this disclosure will be thorough and complete, and will fully convey the concept of the invention to those skilled in the art. Like reference numerals in the drawings denote like elements.

### BRIEF DESCRIPTION OF THE DRAWINGS

The invention will be described in detail with reference to the following drawings in which like numerals refer to like elements.

FIG. 1A is a block diagram illustrating a conventional receiver configured with a receiver chip for receiving S-DMB signals and a receiver chip for receiving T-DMB signals;

FIG. 1B and FIG. 1C are block diagrams illustrating conventional receivers configured with receiver chips each having different frequency bandwidth, respectively;

FIG. 2 is a block diagram illustrating one-chip receiver capable of receiving T-DMB and S-DMB signals in accordance with an exemplary embodiment of the present invention;

FIG. 3 is a block diagram illustrating one-chip receiver capable of receiving S-DMB and WiBro signals in accordance with another exemplary embodiment of the present invention;

FIG. 4 is a block diagram illustrating one-chip receiver capable of receiving T-DMB and WiBro signals in accordance with another exemplary embodiment of the present invention;

FIG. 5 is a view for describing packaging one-chip receiver by stacking and bonding two receiver chips on a monolithic semiconductor integrated circuit substrate and by interconnecting the pads capable of being shared in the two receiver chips in accordance with an embodiment of the present invention;

FIG. 6 is a view for describing packaging one-chip receiver by bonding two receiver chips adjacently to each other on a monolithic semiconductor integrated circuit substrate and by interconnecting the pads capable of being shared in the two receiver chips in accordance with another embodiment of the present invention;

FIG. 7 is a view for describing packaging one-chip receiver by forming and embodying two receiving blocks and a common block capable of being shared by the two receiving blocks on a monolithic semiconductor integrated circuit substrate in accordance with another embodiment of the present invention; and

FIG. 8 is an example of one-chip receiver packaged by stacking and bonding two receiver chips on a monolithic semiconductor integrated circuit substrate and by interconnecting the pads capable of to be shared in the two receiver chips in accordance with an embodiment of the present invention.

### DETAILED DESCRIPTION OF PREFERRED EMBODIMENTS

Hereinafter, exemplary embodiments of the present invention will be described in more detailed manner with reference to the accompanying drawings.

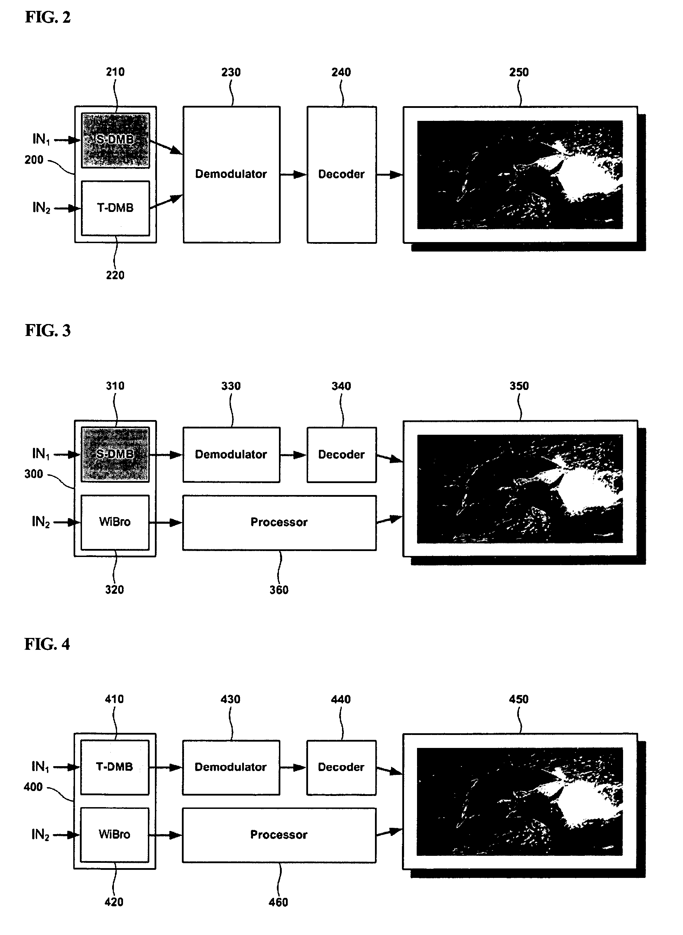

FIG. 2 is a block diagram illustrating one-chip receiver capable of receiving T-DMB and S-DMB signals in accordance with an exemplary embodiment of the present invention.

As shown in FIG. 2, a receiver chip 200 comprises a S-DMB receiver chip 210 and a T-DMB receiver chip 220. A demodulator 230 extracts broadcasting signals from the received signals from the receiver chip 200, and then a decoder 240 extracts image signals to display S-DMB or T-DMB images on a display device 250.

In this configuration, the S-DMB receiver chip 210 and the T-DMB receiver chip 220 are single packaged by using System -in-Package (SiP) technology, and the pins capable of being shared are packaged to be interconnected each other so that the minimum pins are formed outside the receiver chip 200.

Using the single packaged receiver chip 200, the receiver performance improves since the receiver is configured with only one modulator 230 and decoder 240.

Also, the single receiver chip 200 can minimize the area of the chip and lower the power consumption.

Herein, if the S-DMB receiver chip 210 is configured with a dual S-DMB receiver chip using a diversity technique, the S-DMB receiving performance can further improve.

FIG. 3 is a block diagram illustrating one-chip receiver capable of receiving S-DMB and WiBro signals in accordance with another exemplary embodiment of the present invention.

As shown in FIG. 3, a receiver chip 300 comprises a S-DMB receiver chip 310 and a WiBro receiver chip 320. A demodulator 330 extracts broadcasting signals from the received signals from the S-DMB receiver chip 310, and then a decoder 340 extracts image signals to display S-DMB images on a display device 350. The signals received from the WiBro receiver chip 320 are processed by a processor 360 to be displayed on the display device 350.

Herein, the WiBro designates a wireless mobile internet service to display images on the display device 350 via the wireless internet.

In this configuration, the S-DMB receiver chip 310 and the WiBro receiver chip 320 are single packaged by using SiP technology, and the pins capable of being shared are packaged to be interconnected each other so that the minimum pins are formed outside the receiver chip 300.

Using the single packaged receiver chip 300, the overall performance of the receiver improves.

Also, the single receiver chip 300 can minimize the area and lower the power consumption.

Herein, if the S-DMB receiver chip 310 is configured with a dual S-DMB receiver chip using a diversity technique, the S-DMB receiving performance can further improve.

FIG. 4 is a block diagram illustrating one-chip receiver capable of receiving T-DMB and WiBro signals in accordance with another exemplary embodiment of the present invention.

As shown in FIG. 4, a receiver chip 400 comprises a T-DMB receiver chip 410 and a WiBro receiver chip 420. A demodulator 430 extracts broadcasting signals from the received signals from the T-DMB receiver chip 410, and then a decoder 440 extracts image signals to display T-DMB images on a display device 450. The signals received from the WiBro receiver chip 420 are processed by a processor 460 to be displayed on the display device 450.

Herein, the WiBro designates a wireless mobile internet service to display images on the display device 450 via the wireless internet.

In this configuration, the T-DMB receiver chip 410 and the WiBro receiver chip 420 are single packaged by using SiP technology, and the pins capable of being shared are packaged to be interconnected each other so that the minimum pins are formed outside the receiver chip 400

Using the single packaged receiver chip 400, the overall performance of the receiver improves.

Also, the single receiver chip 400 can minimize the area and lower the power consumption.

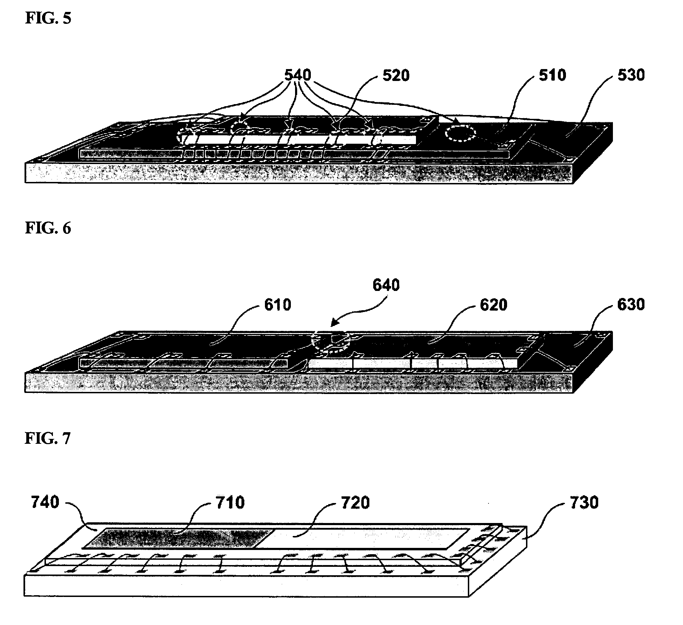

FIG. 5 is a view for describing packaging one-chip receiver by stacking and bonding two receiver chips on a monolithic semiconductor integrated circuit substrate and by interconnecting the pads capable of being shared in the two receiver chips in accordance with an embodiment of the present invention.

Herein, the two receiver chips may be the combinations of two of a S-DMB receiver chip, a diversity S-DMB receiver chip, a T-DMB receiver chip, or a WiBro receiver chip.

Although S-DMB and T-DMB receiver chips are described as an example in this specification, it will be apparent that the two receiver chips may be S-DMB and T-DMB receiver chips, S-DMB and WiBro receiver chips, T-DMB and WiBro receiver chips, or diversity S-DMB and WiBro receiver chips to those skilled in the art.

As shown FIG. 5, a S-DMB receiver chip 510 is disposed on a monolithic semiconductor integrated circuit substrate 530 and isolated from the outside. A T-DMB receiver chip 520 is stacked and bonded on the S-DMB receiver chip 510.

The T-DMB receiver chip 520 comprises a first bonding portion comprising m pads for receiving T-DMB signals, where m is a natural number. The S-DMB receiver chip 510 comprises a second bonding portion comprising n pads for receiving S-DMB signals, where n is a natural number.

The T-DMB and S-DMB receiver chips 510 and 520 are stacked and bonded on the monolithic semiconductor integrated circuit substrate 530 which comprises a third bonding portion comprising k pads, where k is a natural number, and the pads of the first and second bonding portions are wire-bonded to the third bonding portion of the monolithic semiconductor integrated circuit substrate to be packaged.

That is, the pads 540 which can be shared in the S-DMB and T-DMB receiver chips 510 and 520 are wire-bonded between the receiver chips in the package.

As a result, the number of the pads of the third bonding portion, k, is smaller than the sum of the number of the pads of the first bonding portion, m, and the number of the pads of the second bonding portion, n, that is, k<m+n.

Also, if the S-DMB receiver chip 510 is configured with a receiver chip using the diversity technology, the overall size of the receiver is reduced than that of the conventional receiver configured with the respective receiver chips.

Herein, if the S-DMB receiver chip 510 does not use the diversity technology, the stacking order of the S-DMB and T-DMB receiver chip 510 and 520 may change.

That is, the S-DMB receiver chip 510 may be stacked on the T-DMB receiver chip 520.

This configuration can reduce the power consumption of the receiver by stacking and bonding two receiver chips on the monolithic semiconductor integrated circuit substrate and by wire-bonding the pads which can be shared by the two receiver chips.

FIG. 6 is a view for describing packaging one-chip receiver by bonding two receiver chips adjacently to each other on a monolithic semiconductor integrated circuit substrate and by interconnecting the pads capable of being shared in the two receiver chips in accordance with another embodiment of the present invention.

Herein, the two receiver chips may be the combinations of two of a S-DMB receiver chip, a diversity S-DMB receiver chip, a T-DMB receiver chip, or a WiBro receiver chip.

Although S-DMB and T-DMB receiver chips are described as an example in this specification, it will be apparent that the two receiver chips may be S-DMB and T-DMB receiver chips, S-DMB and WiBro receiver chips, T-DMB and WiBro receiver chips, or diversity S-DMB and WiBro receiver chips to those skilled in the art.

As shown FIG. 6, a S-DMB receiver chip 610 is disposed on a monolithic semiconductor integrated circuit substrate 630 and isolated from the outside. A T-DMB receiver chip 620 is bonded adjacently to the S-DMB receiver chip 610 and isolated from the outside.

The T-DMB receiver chip 620 comprises a first bonding portion comprising m pads for receiving T-DMB signals, where m is a natural number. The S-DMB receiver chip 610 comprises a second bonding portion comprising n pads for receiving S-DMB signals, where n is a natural number.

The T-DMB and S-DMB receiver chips 610 and 620 are bonded adjacently to each other on the monolithic semiconductor integrated circuit substrate 630 which comprises a third bonding portion comprising k pads, where k is a natural number, and the pads of the first and second bonding portions are wire-bonded to the third bonding portion of the monolithic semiconductor integrated circuit substrate to be packaged.

That is, the pads 640 which can be shared in the S-DMB and T-DMB receiver chips 610 and 620 are wire-bonded between the receiver chips in the package.

As a result, the number of the pads of the third bonding portion, k, is smaller than the sum of the number of the pads of the first bonding portion, m, and the number of the pads of the second bonding portion, n, that is, k<m+n.

Also, if the S-DMB receiver chip 610 is configured with a receiver chip using the diversity technology, the overall size of the receiver is reduced than that of the conventional receiver configured with the respective receiver chips.

This configuration can reduce the power consumption of the receiver by bonding two receiver chips adjacently to each other on the monolithic semiconductor integrated circuit substrate and by wire-bonding the pads which can be shared by the two receiver chips.

FIG. 7 is a view for describing packaging one-chip receiver by forming and embodying two receiving blocks and a common block capable of being shared by the two receiving blocks on a monolithic semiconductor integrated circuit substrate in accordance with another embodiment of the present invention.

Herein, the two receiving blocks may be the combinations of two of a S-DMB receiving block, a diversity S-DMB receiving block, a T-DMB receiving block, or a WiBro receiving block.

Although S-DMB and T-DMB receiving blocks are described as an example in this specification, it will be apparent that the two receiving blocks may be S-DMB and T-DMB receiving blocks, S-DMB and WiBro receiving blocks, T-DMB and WiBro receiving blocks, or diversity S-DMB and WiBro receiving blocks to those skilled in the art.

As shown FIG. 7, a S-DMB receiving block 710, a T-DMB receiving block 720, and a common block (not shown) are formed in one chip 740 and bonded on a monolithic semiconductor integrated circuit substrate 730.

Herein, the common block is configured with circuits commonly used in the S-DMB and T-DMB receiving blocks 710 and 720, such as a phase locked loop, a local oscillator, or a phase local oscillator.

If the S-DMB receiving block 710 is configured with a receiving block using the diversity technology, the overall size of the receiver is reduced than that of the conventional receiver configured with the respective receiver chips.

This configuration can reduce the power consumption of the receiver by forming two receiving blocks and the common block which can be used commonly in the two receiving blocks in one chip and by bonding the blocks on the monolithic semiconductor integrated circuit substrate.

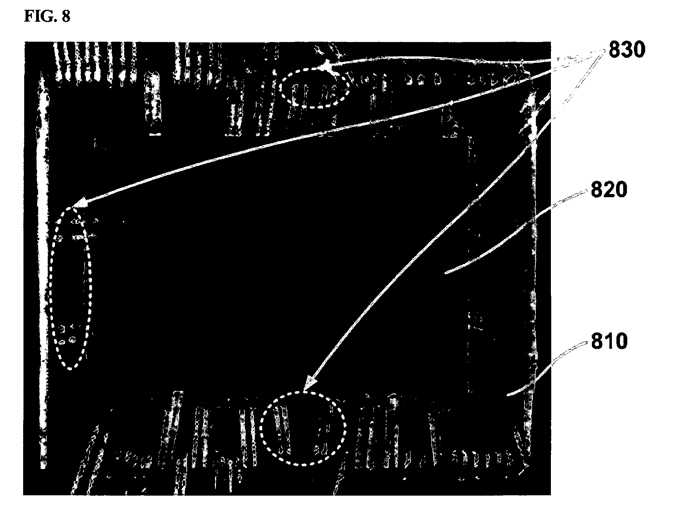

FIG. 8 is an example of one-chip receiver packaged by stacking and bonding two receiver chips on a monolithic semiconductor integrated circuit substrate and by interconnecting the pads capable of to be shared in the two receiver chips in accordance with an embodiment of the present invention.

Herein, the two receiver chips may be the combinations of two of a S-DMB receiver chip, a diversity S-DMB receiver chip, a T-DMB receiver chip, or a WiBro receiver chip.

Although S-DMB and T-DMB receiver chips are described as an example in this specification, it will be apparent that the two receiver chips may be S-DMB and T-DMB receiver chips, S-DMB and WiBro receiver chips, T-DMB and WiBro receiver chips, or diversity S-DMB and WiBro receiver chips to those skilled in the art.

As shown FIG. 8, a T-DMB receiver chip 820 is stacked on a S-DMB receiver chip 810, and pads 830 which can be shared by the S-DMB and T-DMB receiver chip 810 and 820 are interconnected with wire-bonding.

That is, by packaging and interconnecting the pads which can be shared, the number of pins extruded out of the outside is reduced than that of the conventional receiver configured with the respective receiver chips.

This configuration can reduce the volume and power consumption of the receiver, and simplify the receiving end circuitry and the manufacturing process so as to increase the productivity.

As described above, the present invention can reduce the power consumption of the receiver by forming a receiver chip for forming receiving paths of dual frequency bandwidths on a monolithic semiconductor integrated circuit substrate.

Also, the present invention can minimize the receiver by forming a receiver chip for forming receiving paths of dual frequency bandwidths on a monolithic semiconductor integrated circuit substrate.

The foregoing exemplary embodiments and aspects of the invention are merely exemplary and are not to be construed as limiting the present invention. The present teaching can be readily applied to other types of apparatuses. Also, the description of the exemplary embodiments of the present invention is intended to be illustrative, and not to limit the scope of the claims, and many alternatives, modifications, and variations will be apparent to those skilled in the art.

## Claims

1. A receiver chip formed on a monolithic semiconductor integrated circuit substrate, comprising:
a first receiver chip receiving terrestrial digital multimedia broadcasting signals, which comprises a first bonding portion comprising a plurality of pads;
a second receiver chip receiving satellite digital multimedia broadcasting signals, which comprises a second bonding portion comprising a plurality of pads; and
the monolithic semiconductor integrated circuit substrate which comprises a third bonding portion comprising a plurality of pads,
wherein the first and second receiver chips are stacked and bonded on the monolithic semiconductor integrated circuit substrate, and the pads of the first or second bonding portion are wire-bonded to the pads of the third bonding portion.

2. The receiver chip as claimed in claim 1, wherein common pads capable of being used commonly in the first and second bonding portions are wire-bonded to each other.

3. A receiver chip formed on a monolithic semiconductor integrated circuit substrate, comprising:
a first receiver chip receiving terrestrial digital multimedia broadcasting signals, which comprises a first bonding portion comprising a plurality of pads;
a second receiver chip receiving satellite digital multimedia broadcasting signals, which comprises a second bonding portion comprising a plurality of pads; and
the monolithic semiconductor integrated circuit substrate which comprises a third bonding portion comprising a plurality of pads,
wherein the first and second receiver chips are bonded adjacently to each other on the monolithic semiconductor integrated circuit substrate, the pads of the first or second bonding portion are wire-bonded to the pads of the third bonding portion.

4. The receiver chip as claimed in claim 3, wherein, common pads capable of being used commonly in the first and second bonding portions are wire-bonded to each other.

5. A receiver chip formed on a monolithic semiconductor integrated circuit substrate, comprising:
a first receiving block receiving terrestrial digital multimedia broadcasting;
a second receiving block receiving satellite digital multimedia broadcasting; and
a common block used commonly by the first and second receiving blocks,
wherein the first receiving block, the second receiving block, and the common block are isolated one another and formed on one chip to be bonded on the monolithic semiconductor integrated circuit substrate.

6. The receiver chip as claimed in claim 5, wherein the common block comprises one or more of a phase locked loop, a local oscillator, or a phase local oscillator.

7. A receiver chip formed on a monolithic semiconductor integrated circuit substrate, comprising:
a first receiver chip receiving digital multimedia broadcasting signals, which comprises a first bonding portion comprising a plurality of pads;
a second receiver chip communicating in a wireless broadband internet (WiBro) scheme, which comprises a second bonding portion comprising a plurality of pads; and
the monolithic semiconductor integrated circuit substrate which comprises a third bonding portion comprising a plurality of pads,
wherein the first and second receiver chips are stacked and bonded on the monolithic semiconductor integrated circuit substrate, the pads of the first or second bonding portion are wire-bonded to the pads of the third bonding portion.

8. The receiver chip as claimed in claim 7, wherein the first receiver chip is one of a satellite digital multimedia broadcasting receiver chip or a terrestrial digital multimedia broadcasting receiver chip.

9. The receiver chip as claimed in claim 7, wherein, common pads capable of being used commonly in the first and second bonding portions are wire-bonded to each other.

10. A receiver chip formed on a monolithic semiconductor integrated circuit substrate, comprising:
a first receiver chip receiving digital multimedia broadcasting signals, which comprises a first bonding portion comprising a plurality of pads;
a second receiver chip communicating in a WiBro scheme, which comprises a second bonding portion comprising a plurality of pads; and
the monolithic semiconductor integrated circuit substrate which comprises a third bonding portion comprising a plurality of pads,
wherein the first and second receiver chips are bonded adjacently to each other on the monolithic semiconductor integrated circuit substrate, the pads of the first or second bonding portion are wire-bonded to the pads of the third bonding portion.

11. The receiver chip as claimed in claim 10, wherein the first receiver chip is one of a satellite digital multimedia broadcasting receiver chip or a terrestrial digital multimedia broadcasting receiver chip.

12. The receiver chip as claimed in claim 10, wherein, common pads capable of being used commonly in the first and second bonding portions are wire-bonded to each other.

13. A receiver chip formed on a monolithic semiconductor integrated circuit substrate, comprising:
a first receiving block receiving digital multimedia broadcasting;
a second receiving block communicating in a WiBro scheme; and
a common block used commonly by the first and second receiving blocks,
wherein the first receiving block, the second receiving block, and the common block are isolated from one another and formed on the monolithic semiconductor integrated circuit substrate.

14. The receiver chip as claimed in claim 13, wherein the common block comprises one or more of a phase locked loop, a local oscillator, or a phase local oscillator.

15. The receiver chip as claimed in claim 13, wherein the first receiving block is one of a satellite digital multimedia broadcasting receiving chip or a terrestrial digital multimedia broadcasting receiving chip.
